# EUROPÄISCHE PATENTSCHRIFT

(11) **EP 0 472 841 B1**
(45) Veröffentlichungstag und Bekanntmachung des Hinweises auf die Patenterteilung: **26.10.1994**
(21) Anmeldenummer: 91110213.5
(22) Anmeldetag: 21.06.1991
(51) Int. Cl.: H05K 9/00

(54) **Abschirmblech**
Screening sheet
Tôle de blindage

(30) Priorität: 28.07.1990 DE 4024079
(43) Veröffentlichungstag der Anmeldung: 04.03.1992
(73) Patentinhaber: ROBERT BOSCH GMBH, 70442 Stuttgart (DE)
(72) Erfinder: Konz, Horst, W-7253 Renningen (DE); Bentz, Willy, W-7123 Sachsenheim (DE); Hussmann, Dieter, W-7141 Steinheim (DE); Karr, Dieter, Dipl.-Phys., W-7533 Tiefenbronn (DE)

(56) Entgegenhaltungen:
- DE-A- 3 430 755
- DE-A- 3 915 651
- DE-C- 3 916 836
- US-A- 4 851 609

## Beschreibung

### Stand der Technik

Die Erfindung geht aus von einem Abschirmblech zur Bildung einer Kammer zur Aufnahme von elektrischen, insbesondere gedruckten Schaltungen nach DE-A- 39 15 651.6). Unter den in der DE-A- 3915651 behandelten Ausführungsformen ist bereits ein Deckel beschrieben, der zum Verschließen der dem Steckerschacht gegenüberliegenden Öffnung dient. Dieser Deckel weist eine Kühlrippe auf und ist über einen Draht elektrisch leitend mit dem Abschirmpotential der Leiterplatte verbunden. Diese Art der Verbindung ist bei der Montage aufwendig und störend und erschwert weiterhin bei späterem Öffnen des Gehäuses, z. B. bei Wartungsarbeiten, den Zugriff ins Gehäuseinnere und kann leicht abreißen. Um diese Gefahr zu umgehen, muß die elektrisch leitende Verbindung getrennt werden, was einen nicht unerheblichen Aufwand darstellt.

### Vorteile der Erfindung

Das erfindungsgemäße Abschirmblech mit den kennzeichnenden Merkmalen des Hauptanspruchs hat den Vorteil, daß bei einfachem Aufbau eine elektrisch leitende Verbindung zwischen Abschirmblech und Deckel besteht, die auch nach mehrmaligem Öffnen und Schließen des Gehäuses sicher und ohne zusätzlichen Aufwand einen gut leitenden Kontakt herstellt und die Schaltung zuverlässig vor elektrischen und/oder magnetischen Feldern abschirmt.

### Zeichnung

Ein Ausführungsbeispiel der Erfindung ist in der nachfolgenden Beschreibung und Zeichnung näher erläutert. Letztere zeigt in Figur 1 einen Längsschnitt durch ein Gerätegehäuse mit eingesetztem Abschirmblech, in Figur 2 eine Ansicht in das Innere des Gerätegehäuses und in Figur 3 einen Längsschnitt durch einen Deckel.

### Beschreibung des Ausführungsbeispiels

Die Figuren 1 und 2 zeigen ein aus Kunststoff bestehendes Gerätegehäuse 28, in das ein Abschirmblech 1 als Einsatz eingeschoben ist. Das Gerätegehäuse 28 ist der Gestalt des aus dem Abschirmblech gebildeten Kastenprofils 2 formangepaßt; es besitzt einen Aufnahmeschacht 29, der einendig eine Öffnung 30 und anderendig einen Flanschbereich 31 aufweist. Am Flanschbereich 31 sind kragenförmige Vorsprünge 32 mit Bohrungen 33 für Befestigungsschrauben vorgesehen. Der Flanschbereich besitzt ferner einen Steckerschacht 34 zur Aufnahme eines nicht dargestellten Steckers, der an einer in das Innere des kammerförmigen Abschirmbleches 1 einzubringenden, ebenfalls nicht dargestellten Leiterplatte befestigt ist.

Im Bereich der Öffnung 30 ist das Abschirmblech 1 zweimal etwa rechtwinklig zum Rand 35 hin eingeschnitten. Der dadurch gebildete Ausschnitt ist zweimal abgewinkelt. Ein schmaler, parallel zum Rand 35 verlaufender Streifen 37 ist um etwa 180° umgebogen, und der gesamte Ausschnitt 36 ist in das Gehäuseinnere abgewinkelt und bildet einen Einschub.

Figur 3 zeigt einen Deckel 38, mit dem die Gehäuseöffnung 30 verschlossen wird. Der Deckel ist an seiner Außenseite mit Kühlrippen 39 und einem Steg 40 versehen. In dem Steg sind Bohrungen 41 angebracht, die zur Befestigung am Einbauort dienen.

An der Innenseite des Deckels ist ein metallischer Winkel 42 befestigt, z. B. vernietet. Die Breite des Winkels entspricht der Breite des Ausschnittes 36 im Abschirmblech. Der Winkel 42 ist so an dem Deckel angeordnet, daß beim Zusammenfügen von Gehäuse 28 und Deckel 38 der ins Gehäuseinnere weisende Winkelabschnitt dem durch den Ausschnitt 36 gebildeten Einschub gegenüberliegt.

Bei der Montage wird zunächst das Kastenprofil 2 durch die Öffnung 30 in das Innere des Gerätegehäuses eingeschoben. Anschließend wird die Leiterplatte durch die Öffnung 30 in das Innere des Gerätegehäuses eingeschoben und ihr Stecker mittels geeigneter Befestigungsmittel im Steckerschacht 34 festgelegt. Über den Stecker wird der Leiterplatte ein geeignetes Abschirmpotential, z. B. Masse, zugeführt. Zum Verschließen der Öffnung 30 wird der Deckel so an dem Gehäuse angebracht, daß der Winkel 42 zwischen Gehäuseinnenwand und Ausschnitt 36 eingeschoben ist und Ausschnitt 36 und Winkel 42 zumindest mit einem Teil ihrer Oberflächen aufeinanderliegen. Dadurch entsteht über den Winkel ein elektrisch gut leitender Kontakt zwischen Abschirmblech 1 und Deckel 38.

Sollen an der Innenseite des mit Kühlrippen 39 versehenen Deckels 38 zur besseren Wärmeableitung Leistungsbauelemente angebracht werden, wird der Deckel auf dazu geeignete Weise an der Leiterplatte befestigt. Die Leiterplatte wird dann zum Zusammenbau in das mit dem Kastenprofil 2 versehene Gehäuse eingeschoben, so daß der Stecker in den Steckerschacht ragt und gleichzeitig der Deckel die Öffnung 30 verschließt. Dabei entsteht wieder der Kontakt zwischen Winkel und Einschub, so daß auch in diesem Fall die leitende Verbindung zwischen Abschirmblech und Deckel gewährleistet ist.

## Patentansprüche

1. Abgeschirmter Kammer zur Aufnahme von elektrischen, insbesondere gedruckten Schaltungen, mit einem Abschirmblech mit mindestens zwei verschachtelt ineinandergreifenden Randbereichen, die randoffene Ausnehmungen und beiderseits jeder Ausnehmung gelegene Verschlußzungen aufweisen, und die Ausnehmungen beider Randbereiche unter gegenseitiger Abstützung ineinandergreifen, wobei die Verschlußzungen flächig überlappend aufeinanderliegen, dadurch gekennzeichnet, daß die Kammer einseitig durch einen Deckel (38) verschlossen ist, der an seiner Innenseite einen in die Kammer weisenden, metallischen Winkel (42) aufweist, daß im Abschirmblech (1) im Bereich der durch den Deckel (38) zu verschließenden Öffnung (30) ein Einschub (36) gebildet ist, und daß der Winkel (42) und der Einschub (36) mindestens mit einem Teil ihrer Oberflächen leitend aneinanderliegen.

2. Kammer nach Anspruch 1, dadurch gekennzeichnet, daß der Einschub (36) durch einen nach innen abgewinkelten Randbereich des Abschirmbleches (1) gebildet ist.

## Claims

1. Screened chamber for accommodating electrical, especially printed circuits, having a screening plate having at least two edge regions which engage in one another in an interleaved manner and have recesses, which are open at the edges, and closure tongues located on both sides of each recess, and the recesses of both edge regions engage in one another providing mutual support, the closure tongues resting flat on one another in an overlapping manner, characterized in that the chamber is closed on one side by a cover (38) which, on its inside, has a metallic angle bracket (42) which points into the chamber, in that a push-in device (36) is formed in the screening plate (1) in the region of the opening (30) which is to be closed by the cover (38), and in that at least a portion of the surfaces of the angle bracket (42) and of the push-in device (36) rest against one another conductively.

2. Chamber according to Claim 1, characterized in that the push-in device (36) is formed by an edge region, which is bent inwards, of the screening plate (1).

## Revendications

1. Chambre blindée destinée à recevoir des circuits électriques, en particulier des circuits imprimés, avec une tôle blindée, avec au moins deux zones de bord emmanchées de manière imbriquée, qui comportent des évidements de bord ouverts et des languettes de fermeture placées des deux côtés de chaque évidement, et les évidements des deux zones de bord s'emmanchent en un appui réciproque, les languettes de fermeture se situant l'une sur l'autre en se recouvrant en surface, caractérisée :
- en ce que la chambre est fermée d'un côté par un couvercle (38), qui comporte sur sa face interne une cornière métallique (42), tournée vers la chambre,
- en ce que dans la tôle de blindage (1) forme, dans la zone de l'ouverture (30) à fermer par le couvercle (38), un dispositif emmanchable (36) et,
- en ce que la cornière (42) et le dispositif emmanchable (36) sont situés l'un contre l'autre sur au moins une partie de leurs surfaces de manière conductrice de l'électricité.

2. Chambre selon la revendication 1, caractérisée en ce que le dispositif enfichable (36) est formé par une zone de bord de la tôle de blindage (1) pliée vers l'intérieur.
